# FASCICULE DE BREVET EUROPEEN

(11) **EP 3 008 252 B1**
(45) Date de publication et mention de la délivrance du brevet: **11.10.2017**
(21) Numéro de dépôt: 14734880.9
(22) Date de dépôt: 11.06.2014
(51) Int. Cl.: E02D 17/13

(54) **PROCEDE ET INSTALLATION DE FABRICATION D'UNE PAROI CONTINUE DANS LE SOL**
VERFAHREN UND VORRICHTUNG ZUM HERSTELLEN EINER SCHLITZWAND
METHOD AND DEVICE FOR MAKING A DIAPHRAGM WALL

(30) Priorité: 12.06.2013 FR 1355437
(43) Date de publication de la demande: 20.04.2016
(73) Titulaire: Soletanche Freyssinet SA, 92500 Rueil Malmaison (FR)
(72) Inventeur: STEFF DE VERNINAC, Bertrand, F-92500 Rueil Malmaison (FR); DARSON-BALLEUR, Sabine, F-92500 Rueil Malmaison (FR); RENALIER, Florence, F-92500 Rueil Malmaison (FR); COUDRY, Michel, F-92500 Rueil Malmaison (FR)
(74) Mandataire: Balesta, Pierre
(86) Numéro de dépôt international: PCT/FR2014/051412
(87) Numéro de publication internationale: WO 2014/199078

(56) Documents cités:
- FR-A1- 2 891 287

## Description

### Arrière-plan de l'invention

La présente invention concerne le domaine du forage et de l'excavation d'écrans dans le sol. Elle trouve notamment son application dans le cadre de la réalisation d'ouvrages très profonds, notamment à une profondeur de plus de cinquante mètres.

Par « écrans », on entend notamment mais pas uniquement les parois moulées qui sont réalisées dans le sol.

L'invention porte plus particulièrement sur un procédé de fabrication d'une paroi continue dans un sol, dans lequel :
- on fournit une machine d'excavation comportant un châssis ayant une direction longitudinale, ledit châssis ayant une extrémité inférieure et portant un dispositif de coupe disposé en son extrémité inférieure ;
- on réalise une étape de fabrication d'un premier écran dans le sol, qui comprend une première étape de forage à l'aide de la machine d'excavation;
- on réalise une deuxième étape de forage à l'aide de la machine d'excavation afin de fabriquer un deuxième écran dans le sol qui soit juxtaposé au premier écran de sorte que les premier et deuxième écrans soient sécants.

La machine d'excavation utilisée dans ce procédé est généralement une foreuse à tambours rotatifs, telle que celle décrite dans FR 2891287 A1. La machine est suspendue à un engin de levage par l'intermédiaire de câbles.

Au cours de la première étape de forage, le châssis poursuit un mouvement de descente au fur et à mesure que son dispositif de coupe creuse la tranchée.

Pour certains travaux, la tranchée peut présenter une grande profondeur qui peut atteindre cent mètres ou davantage.

En outre, il est généralement nécessaire que cette tranchée présente une grande précision quant à sa verticalité notamment du fait que la paroi finale résulte de la juxtaposition d'écrans sécants.

Cependant, en raison de la présence des irrégularités du sol, il existe des risques importants que le châssis dévie de sa trajectoire verticale, ce risque étant plus important pour les ouvrages de grande profondeur.

Il existe donc un risque important que la paroi finale ne soit pas continue, ou sécante seulement sur une épaisseur de recouvrement insuffisante.

Dans la mesure où la paroi finale doit le plus souvent être étanche, on comprend qu'il existe un réel besoin de pouvoir assurer la continuité de la paroi réalisée.

Pour résoudre ce problème, notamment dans le cadre de forages à grandes profondeurs, il est connu d'augmenter l'épaisseur des écrans. Toutefois, cette solution entraine une augmentation sensible des ressources consommées et du coût de fabrication de la paroi continue, ce qui n'est pas désirable.

### Objet et résumé de l'invention

Un but de l'invention est de remédier aux inconvénients précités en proposant un procédé de fabrication d'une paroi continue dans un sol, qui permet d'assurer la continuité de la paroi, en particulier dans le cadre de parois de grande profondeur.

L'invention atteint son but par le fait que, au cours de la deuxième étape de forage :
- on détermine périodiquement l'écart entre le châssis et le premier écran ; et
- on corrige périodiquement la position du châssis afin de réduire l'écart déterminé à l'étape précédente en sorte de maintenir un recouvrement entre le bord longitudinal du châssis et le bord longitudinal du premier écran, de manière que le deuxième écran soit sécant au premier écran sur toute la longueur du plus court des premier et deuxième écrans, grâce à quoi on forme la paroi continue.

On entend par « longueur du premier (ou deuxième) écran », la plus grande des dimensions dudit écran. Par « largeur », on entend la plus grande des dimensions de l'écran après sa longueur, tandis que par « épaisseur » on entend la plus petite des trois dimensions.

Par ailleurs, au sens de l'invention, on entend par « premier écran », aussi bien un élément de paroi bétonné, comme par exemple une paroi moulée, qu'un élément excavé rempli de boue de forage.

Par « sécant », on entend que les premier et deuxième écrans ont une intersection commune, cette intersection étant constituée par le recouvrement du bord longitudinal du premier écran avec le bord longitudinal du deuxième écran qui lui fait face. Ce recouvrement s'étend selon une épaisseur considérée dans un plan horizontal, appelée épaisseur de recouvrement. Selon l'invention, on cherche à maintenir une épaisseur de recouvrement qui soit non nulle et préférentiellement supérieure à un seuil prédéterminé, qui est par exemple fonction de l'épaisseur du premier écran.

Ainsi, au sens de l'invention, la trajectoire du châssis dans le sol est fonction de la forme et de la déviation éventuelle du premier écran qui a été préalablement fabriqué. En d'autres termes, le deuxième écran est fabriqué de manière relative par rapport au premier écran, en tenant compte de l'orientation et de la déviation éventuelle du premier écran préalablement fabriqué, et ce afin d'assurer la continuité de la juxtaposition bord contre bord des écrans, et ce sur toute la longueur du plus court des premier et deuxième écrans.

On comprend que le procédé de fabrication selon l'invention cherche en premier lieu à maintenir le recouvrement entre le bord longitudinal du châssis et le bord longitudinal du premier écran qui lui fait face, afin de garantir la continuité entre les premier et deuxième écrans juxtaposés, quand bien même la paroi continue obtenue n'est pas purement verticale. Pour la fabrication du deuxième écran, on se sert donc du premier écran précédemment fabriqué comme référence ou guide pour le déplacement du châssis.

Par conséquent, la fabrication du deuxième écran est réalisée au plus juste de sorte qu'il n'est pas nécessaire de surdimensionner l'épaisseur des écrans.

Préférentiellement, la correction périodique consiste à annuler l'écart déterminé entre le châssis et le premier écran. On assure alors une continuité parfaite entre les premier et deuxième écrans.

Toutefois, et sans sortir du cadre de la présente invention, la correction pourra seulement consister à réduire, sans toutefois l'annuler, l'écart déterminé entre le châssis et le premier écran. Un intérêt est de réduire, dans la mesure du possible, une éventuelle déviation du second écran par rapport à la verticale, tout en préservant bien évidemment la continuité de paroi. En tout état de cause, pour assurer la continuité entre les deux écrans, la composante de l'écart considérée selon une direction perpendiculaire à la surface moyenne du premier écran doit rester strictement inférieure à l'épaisseur des écrans.

De préférence, on cherchera à réduire au maximum cet écart de sorte que l'épaisseur de recouvrement soit au moins égale à une épaisseur minimale prédéterminée, par exemple 60% de l'épaisseur de l'écran.

Aussi, de manière avantageuse, la position du châssis est corrigée de manière que l'épaisseur de recouvrement soit au moins égale à cette épaisseur minimale prédéterminée.

Avantageusement, l'étape de détermination de l'écart entre le châssis et le premier écran est réalisée toutes les 30 à 60 minutes, ou tous les 1 à 5 mètres. De préférence, la détermination de l'écart est réalisée en temps réel.

Cette étape de détermination de l'écart entre le châssis et le premier écran est réalisée en mesurant la position relative du châssis par rapport au premier écran précédemment réalisé.

Pour ce faire, de préférence, au cours de la deuxième étape de forage, on mesure périodiquement une grandeur physique à l'aide du châssis, et l'écart entre le châssis et le premier écran est déterminé à l'aide des valeurs mesurées de ladite grandeur physique.

Pour réaliser l'étape de correction, le châssis est avantageusement équipé de moyens de correction de trajectoire, connus par ailleurs. Il pourra par exemple s'agir de patins d'appui, actionnés par des vérins hydrauliques, montés sur les faces et bords longitudinaux du châssis. Lorsqu'ils sont actionnés, les patins prennent appui sur les pans de la tranchée afin de modifier la position du châssis dans la tranchée.

Avantageusement, la grandeur physique est mesurée en continue de sorte que l'écart est déterminé en temps réel. De préférence, l'écart, ou bien une représentation graphique dudit écart, est affiché en temps réel dans la cabine de la machine ou dans tout autre site opérationnel du chantier.

Selon un premier mode de mise en oeuvre, on place au moins une électrode dans le premier écran ; au cours de la deuxième étape de forage, on mesure une grandeur physique du bord longitudinal du châssis qui est en regard du bord longitudinal du premier écran, et, on détermine l'écart entre le châssis et le premier écran à partir des valeurs de grandeurs physiques mesurées.

De préférence, la grandeur physique mesurée est un potentiel électrique.

Aussi, dans le premier mode de mise en oeuvre, on mesure périodiquement le potentiel électrique du bord longitudinal du châssis qui est en regard du bord longitudinal du premier écran afin de déterminer l'écart entre le châssis et le premier écran. En pratique, on constate une diminution du potentiel électrique mesuré lorsque le châssis s'éloigne du premier écran.

De préférence, l'électrode s'étend sur tout ou partie de la longueur du premier écran.

Encore de préférence, et pour améliorer la précision de la mesure, on place une pluralité d'électrodes dans le premier écran, les électrodes étant disposées selon une rangée qui s'étend selon l'épaisseur du premier écran, et les électrodes sont mises à un potentiel prédéterminé.

Selon une variante du premier mode de mise en oeuvre, au moins une pièce métallique est placée dans le premier écran lors de sa fabrication, ladite pièce métallique s'étendant selon la longueur du premier écran ; le châssis est muni d'un appareil de mesure et, au cours de la deuxième étape de forage, on détermine l'écart entre le châssis et le premier écran à partir des valeurs mesurées par l'appareil de mesure.

De préférence, la pièce métallique est une cage d'armature qui est noyée dans le premier écran, et l'appareil de mesure est un appareil mesurant un champ électrique, ou électromagnétique ou magnétique. Cet appareil est par exemple une antenne radar ou par exemple encore d'un dispositif constitué d'une ou plusieurs électrodes.

De préférence, on place une pluralité de pièces métalliques dans le premier écran, les pièces métalliques étant disposées selon une rangée qui s'étend selon l'épaisseur du premier écran, et les pièces métalliques sont préférentiellement, mais pas nécessairement, mises à un potentiel prédéterminé. Cette pluralité de pièces métalliques forme de préférence la cage d'armature précitée.

Selon un deuxième mode de mise en oeuvre, combinable avec le premier mode de mise en oeuvre, on fabrique le premier écran à partir d'un mélange d'un liant hydraulique et d'un marqueur ; au cours de la deuxième étape de forage, on détecte la présence du marqueur à l'aide d'au moins un détecteur disposé dans le châssis, et on détermine l'écart entre le châssis et le premier écran à partir des valeurs fournies par le détecteur.

De préférence, le marqueur est un élément radioactif, par exemple du chlorure de potassium, du thorium, du rubidium ou toute autre source radioactive. Selon une autre variante, le marqueur est un élément pulvérulent métallique comme par exemple de la poudre, de la fibre ou bien encore de la limaille. Il pourra par exemple s'agir de poudre de fer ou tout autre type d'élément pouvant être mélangé avec le liant.

Avantageusement, le détecteur est de type Gamma dans le cas d'une source radioactive mélangée au liant. Il peut également s'agir d'un détecteur configuré pour mesurer la résistivité, la polarisation ou bien encore le champ électrique ou électromagnétique dans le matériau constitutif du premier écran.

Pour améliorer la précision des résultats, le bord longitudinal du châssis est muni d'au moins une bande de détecteurs qui s'étend selon toute ou partie de l'épaisseur du châssis et éventuellement sur les autres côtés du châssis.

Selon un troisième mode de mise en oeuvre, combinable avec au moins l'un des modes de mise en oeuvre précités, le bord longitudinal du châssis est muni de capteurs permettant de mesurer, au cours de la deuxième étape de forage, la résistivité électrique ou la résistance mécanique du milieu au contact des capteurs ; on détermine l'écart entre le châssis et le premier écran à partir des mesures fournies par les capteurs.

Ces capteurs sont configurés pour identifier et différencier les matériaux constitutifs du milieu au contact des capteurs. Ces matériaux sont par exemple du liquide, du béton ou du sol.

Pour la mesure de la résistivité électrique, on utilisera comme capteurs des électrodes, tandis que pour mesurer la résistance mécanique, on pourra utiliser des palpeurs configurés pour venir au contact du pan de la tranchée.

Selon un quatrième mode de mise en oeuvre, combinable avec au moins l'un des modes de mise en oeuvre précités, le châssis comporte des sources émettrices et réceptrices d'ondes qui sont disposées de part et d'autre de l'épaisseur du châssis ; au cours de la deuxième étape de forage, les sources émettrices et réceptrices d'ondes émettent des ondes vers le premier écran puis mesurent les ondes réfléchies, et on détermine l'écart entre le châssis et le premier écran à partir des mesures fournies par les sources émettrices et réceptrices d'ondes.

Les sources émettrices et réceptrices d'ondes permettent de visualiser « en aveugle » le milieu avoisinant. De préférence, on met en oeuvre une méthode d'imagerie acoustique.

Selon un cinquième mode de mise en oeuvre, combinable avec au moins l'un des modes de mise en oeuvre précités, on ménage au moins une cavité longitudinale dans le premier écran et, au cours de la deuxième étape de forage, on descend un émetteur, respectivement un récepteur, dans la cavité à une vitesse identique à la vitesse de descente du châssis, ledit châssis étant quant à lui équipé d'un récepteur, respectivement d'un émetteur ; l'émetteur émet un signal qui est reçu par le récepteur, et on détermine l'écart entre le châssis et le premier écran à partir du signal reçu par le récepteur.

Avantageusement, le signal est électrique ou électromagnétique, ou magnétique. De manière alternative, le signal est un rayonnement X.

De préférence, la cavité longitudinale est constituée par une pièce creuse placée dans le premier écran lors de sa fabrication. Cette pièce creuse est de préférence constituée d'un tube creux s'étendant selon tout ou partie de la longueur du premier écran. La position de la cavité longitudinale par rapport au premier écran est connue.

Selon un sixième mode de mise en oeuvre combinable avec au moins l'un des modes de mise en oeuvre précités, on ménage au moins une cavité longitudinale dans le sol au voisinage du premier écran, et, au cours de la deuxième étape de forage, on descend un émetteur, respectivement un récepteur, dans la cavité à une vitesse identique à la vitesse de descente du châssis, ledit châssis étant quant à lui équipé d'un récepteur, respectivement d'un émetteur ; l'émetteur émet un signal qui est reçu par le récepteur, et dans lequel on détermine l'écart entre le châssis et le premier écran à partir du signal reçu par le récepteur. La position en X Y Z de ladite au moins une cavité est connue.

De préférence, plusieurs cavités, dont les positions sont connues, sont utilisées pour positionner le châssis par rapport au premier écran. Ces cavités sont préférentiellement disposées de part et d'autre des écrans.

L'invention porte par ailleurs sur une installation de fabrication d'une paroi continue dans le sol, pour la mise en oeuvre du procédé selon l'invention, qui comporte :
- des moyens pour fabriquer un premier et un deuxième écran dans le sol qui comprennent une machine d'excavation comportant un châssis ayant une extrémité inférieure et portant un dispositif de coupe disposé en son extrémité inférieure ;
- des moyens pour déterminer périodiquement l'écart entre le châssis et le premier écran lors de la fabrication du deuxième écran dans le sol ; et
- des moyens de correction pour corriger périodiquement la position du châssis afin de réduire l'écart déterminé entre le châssis et le premier écran, en sorte de maintenir un recouvrement entre le bord longitudinal du châssis et le bord longitudinal du premier écran, de manière que le deuxième écran soit sécant au premier écran sur toute la longueur du plus court des premier et deuxième écrans, grâce à quoi on forme la paroi continue.

Les moyens pour déterminer périodiquement l'écart entre le châssis et le premier écran correspondent notamment à ceux qui ont été définis précédemment.

Les moyens de correction comportent préférentiellement des patins hydrauliques montés sur le châssis et qui sont configurés pour prendre appui et pousser sur les pans de la tranchée, et ce afin de modifier la trajectoire du châssis. La modification de la trajectoire du châssis est réalisée de manière à réduire ou annuler l'écart déterminé entre les bords longitudinaux du châssis et du premier écran qui sont en vis-à-vis.

### Brève description des dessins

L'invention sera mieux comprise à la lecture de la description qui suit de modes de réalisation de l'invention donnés à titre d'exemples non limitatifs, en référence aux dessins annexés, sur lesquels :
- la figure **1** est une vue de l'installation de fabrication d'une paroi continue selon l'invention, mettant en oeuvre le procédé de fabrication selon un mode de mise en oeuvre de l'invention, la machine d'excavation débutant le forage du deuxième écran et le premier écran étant pourvu d'électrodes ;
- la figure **2** est une vue de l'installation de la figure **1****,** dans laquelle la trajectoire du châssis a été corrigée pour suivre la courbure du premier écran ;
- la figure **3** est une vue de détail d'un exemple de moyens de détermination de l'écart entre le châssis et le premier écran ;
- la figure **4** illustre les premier et deuxième écrans juxtaposés et sécants qui forment une paroi continue ;
- la figure **5** illustre une variante de l'installation de la figure **1** mettant en oeuvre le procédé selon un autre mode de mise en oeuvre, dans lequel une sonde est descendue dans un canal longitudinal ménagé dans le premier écran ;
- la figure **6A** est une vue en coupe transversale du châssis et du premier écran muni d'une cage d'armature, cette figure illustrant de manière schématique la position des capteurs sur le châssis selon un exemple de réalisation de l'installation selon l'invention;
- la figure **6B** illustre les données graphiques apparaissant sur l'écran de contrôle relié aux capteurs du châssis de la figure **6A** ;
- la figure **7A** montre une variante de l'installation de la figure **6A****,** le premier écran étant constitué d'un mélange de liant et d'un marqueur radioactif, tandis que le châssis est muni de détecteurs Gamma ;
- la figure **7B** illustre les données graphiques apparaissant sur l'écran de contrôle relié aux détecteurs du châssis de la figure **7A** ;
- la figure **8A** montre une variante de l'installation de la figure **6A****,** le châssis étant muni d'électrodes afin de mesure la résistivité du milieu avoisinant ;
- la figure **8B** illustre les données graphiques apparaissant sur l'écran de contrôle relié aux détecteurs de la figure **8A** ;
- la figure **9A** montre une variante de l'installation de la figure **6A****,** dans laquelle le châssis est muni de deux sonars ; et
- la figure **9B** illustre les données graphiques apparaissant sur l'écran de contrôle relié aux sonars du châssis de la figure **9A****.**

### Description détaillée de l'invention

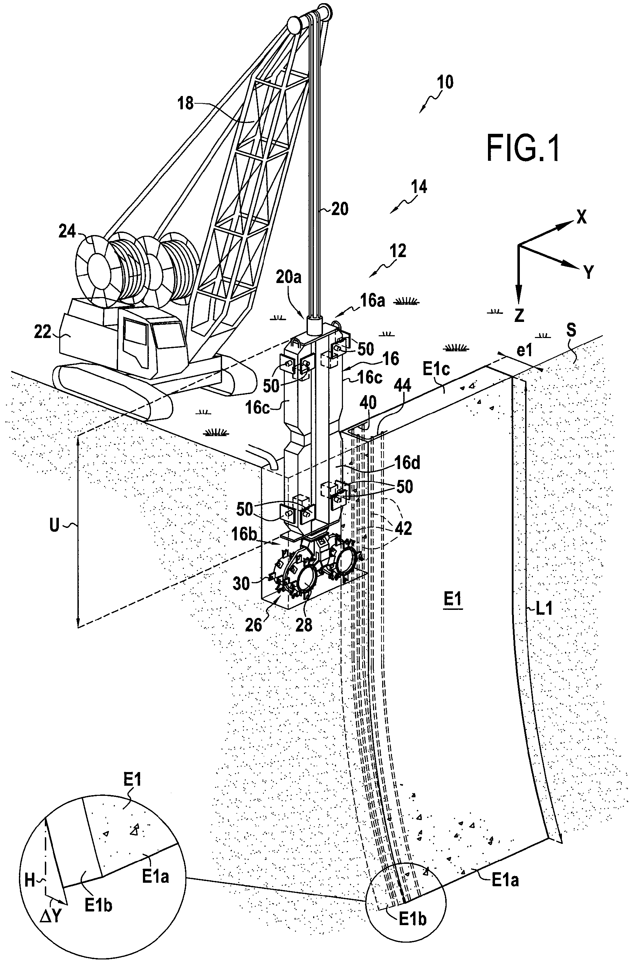

Sur la figure **1****,** on a représenté un premier exemple de réalisation d'une installation **10** de fabrication d'une paroi continue dans un sol **S** conforme à la présente invention. Cette installation **10** est destinée à mettre en oeuvre le procédé selon l'invention qui va être décrit ci-après.

Cette installation **10** comporte des moyens de fabrication d'écrans **12** dans le sol qui comprennent une machine d'excavation **14** comportant un châssis **16.** Dans cet exemple, le châssis est suspendu à l'extrémité supérieure d'un mât **18** par l'intermédiaire de câbles de sustentation **20.**

Le mât **18** est relié à un porteur mobile **22.** Les câbles **20** sont quant à eux reliés, de manière connue, à des enrouleurs **24** montés sur le porteur **22.**

Le châssis **16** comporte une extrémité supérieure **16**a qui est reliée à l'extrémité inférieure **20a** des câbles de sustentation **20,** ainsi qu'une extrémité inférieure **16b** qui porte un dispositif de coupe référencé **26.**

Dans cet exemple, le dispositif de coupe **26** est constitué de deux tambours rotatifs **28** munis de dents de coupe **30** dont les axes de rotation s'étendent transversalement par rapport à la direction longitudinale **U** du châssis **16.**

Comme on le constate sur la figure **1****,** la machine d'excavation **14** est configurée pour réaliser une excavation dans le sol qui s'étend selon une direction sensiblement verticale.

Dans la suite de la description, on se réfèrera au repère XYZ illustré sur la figure 1, dans lequel Z représente la direction verticale, X une direction horizontale qui s'étend selon la largeur de l'écran, et Y une autre direction horizontale orthogonales aux directions X et Z.

Sur l'exemple de la figure **1****,** un premier écran **E1** a déjà été fabriqué dans le sol à l'aide de la machine d'excavation **14.** Dans cet exemple, le premier écran **E1** est une paroi moulée dans le sol. Pour la fabriquer, de manière traditionnelle, on a réalisé une excavation à l'aide de la machine d'excavation **14** tout en injectant une boue de forage, après quoi on a inséré une cage d'armature **40** dans l'excavation avant de remplir cette dernière de béton tout en évacuant la boue de forage. De manière classique, la cage d'armature **40** est constituée de barres métalliques longitudinales **42** qui s'étendent sur sensiblement toute la longueur **L1** du premier écran **E1.** Les barres **42** sont reliées les unes aux autres par le biais de traverses **44.**

On précise ici que la longueur **L1** du premier écran **E1** correspond à sa plus grande dimension.

Dans cet exemple, le premier écran **E1** a été réalisé à une grande profondeur, supérieure à 50 mètres. Dans la mesure où le sol **S** n'est pas homogène, et présente certaines irrégularités, on constate que le premier écran **E1** n'est pas purement vertical. Bien évidemment, la déviation illustrée sur la figure **1** a été exagérée.

Dans cet exemple, la déviation ΔY à l'extrémité inférieure **E1a** du premier écran **E1** selon la direction Y est de l'ordre de 0.30 m.

Bien évidemment, plus la longueur **L1** du premier écran **E1** est grande, plus le risque est élevé que la déviation ΔY soit importante.

Sur la figure **1****,** on constate que le bord longitudinal **E1b** du premier écran **E1** présente un profil légèrement incurvé, la déviation du premier écran **E1** étant dirigée, comme évoqué précédemment, selon la direction Y.

Dans l'exemple de la figure **1****,** la machine d'excavation **14** est en cours de réalisation d'un deuxième forage afin de fabriquer un deuxième écran **E2** dans le sol **S** qui soit juxtaposé et sécant au premier écran **E1** préalablement fabriqué.

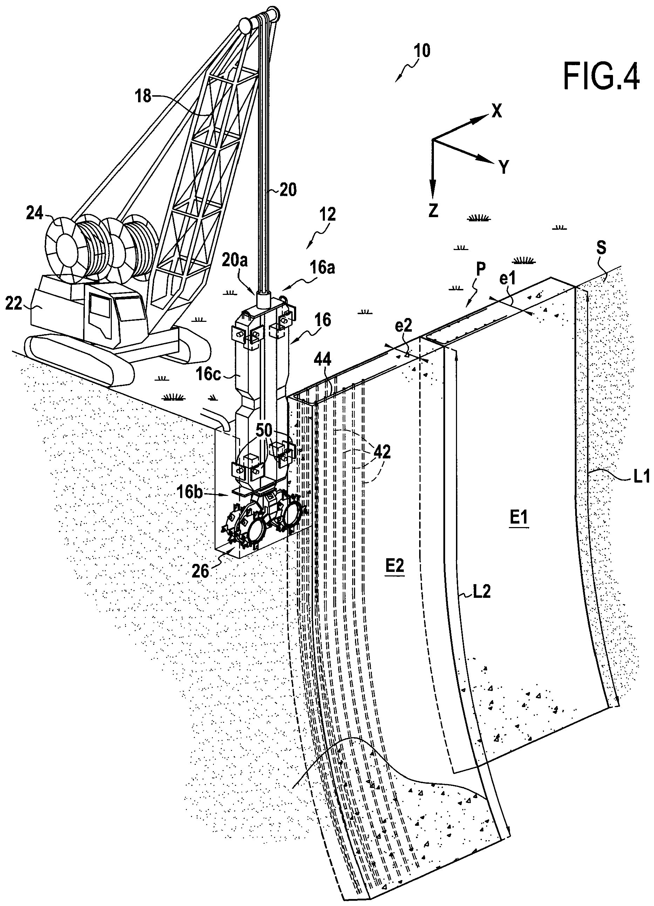

Comme on le comprend à l'aide de la figure **4****,** le deuxième écran **E2** est fabriqué de manière à être juxtaposé au premier écran **E1** de sorte que les premier et deuxième écrans soient sécants, et ce de manière à réaliser une paroi continue **P** dans le sol **S.**

Dans cet exemple non limitatif, le deuxième écran **E2** que l'on souhaite fabriquer présente une longueur **L2** qui est strictement supérieure à la longueur **L1** du premier écran **E1** précédemment fabriqué ; les épaisseurs **e1** et **e2** des premier et deuxièmes écrans **E1, E2** sont quant à elles sensiblement égales.

Le châssis **16** comporte deux bords longitudinaux **16c** qui s'étendent parallèlement à la direction longitudinale **U** du châssis **16,** de part et d'autre de la largeur du châssis. Par largeur du châssis, on entend la dimension du châssis qui est plus petite que la longueur ou hauteur du châssis, mais plus grande que son épaisseur. Dans cet exemple, la largeur du châssis **16** s'étend selon l'axe **X** du repère défini plus haut.

Conformément à l'invention, après la fabrication du premier écran **E1,** on réalise une deuxième étape de forage illustrée sur la figure **1** au cours de laquelle on détermine périodiquement un écart δ éventuel entre le châssis **16** et le premier écran **E1.**

Dans le repère XYZ, cet écart δ a pour composantes δx et δy, ces composantes étant définies selon les axes **X** et **Y** définis précédemment.

En d'autres termes, cet écart δ correspond à la distance entre le châssis et le premier écran, considérée selon la direction **X,** et/ou le déplacement relatif du châssis par rapport au premier écran selon la direction **Y.**

Dans l'exemple de la figure **1****,** la deuxième étape de forage est réalisée en mordant sur l'extrémité transversale **E1c** du premier écran **E1,** de sorte que, dans cet exemple non limitatif, on ne s'intéresse qu'à l'écart δy correspondant à un déport transversal du plan dans lequel s'étend le châssis par rapport à la surface moyenne du premier écran **E1.** Selon une variante, on contrôle que le premier écran est mordu, par exemple en contrôlant la position du châssis et la valeur des couples exercés par les moteurs de rotation des tambours. On s'assure ainsi que l'écart δx reste négatif. A défaut, la position du châssis est corrigée. De préférence mais pas uniquement, l'écart δy est déterminé en continu ou bien périodiquement, par exemple en réalisant un cycle de mesure toutes les 30 minutes.

De préférence, cet écart est mesuré entre un point du châssis **16** et le premier écran **E1.** Selon une variante, cet écart est déterminé entre plusieurs points du châssis et le premier écran **E1,** puis l'on moyenne les écarts déterminés afin d'obtenir un écart moyen entre le châssis et le premier écran. Selon une autre variante, cet écart est déterminé entre un ou plusieurs points du châssis et un ou plusieurs éléments dans le sol encaissant **S.**

Conformément à l'invention, lorsqu'un écart δy est déterminé, on corrige périodiquement la position du châssis **16** afin de réduire l'écart δy en sorte de maintenir une épaisseur de recouvrement **K** entre le bord longitudinal **E1b** du premier écran et le bord longitudinal **16c** du châssis **16.** La correction est réalisée de sorte que l'épaisseur de recouvrement **K** est au moins égale à une épaisseur minimale prédéterminée, par exemple 60 % de l'épaisseur du châssis.

Dans la mesure où, dans cet exemple non limitatif, l'épaisseur du châssis **16** est sensiblement égale à l'épaisseur du deuxième écran, on comprend alors que cette correction permet de maintenir un recouvrement entre les bords longitudinaux des premier et deuxième écrans **E1, E2.** Cela permet d'assurer que le deuxième écran **E2** reste sécant au premier écran **E1** sur toute la longueur **L1** du plus court des premier et deuxième écrans, en l'espèce le premier écran **E1** étant le plus court, grâce à quoi on assure la continuité entre le premier écran **E1** et le deuxième écran **E2.**

En conséquence, la juxtaposition des premier et deuxième écrans **E1, E2** forme un élément de paroi continue. On comprend que la continuité s'entend du recouvrement des bords longitudinaux des premier et deuxième écrans sur la longueur du plus court des premier et deuxième écrans juxtaposés. Cette continuité est bien visible sur la figure **4** qui illustre la juxtaposition des premier et deuxième écrans **E1, E2.**

Pour réaliser cette correction périodique, le châssis **16** est avantageusement muni de patins d'appui **50** qui sont disposés sur les faces longitudinales **16** du châssis ainsi que sur les bords longitudinaux **16c** du châssis **16.** Ces patins sont actionnés par des vérins de manière à prendre appui sur le pan de la tranchée en cours d'excavation, ce qui a pour effet de modifier la trajectoire du châssis.

De préférence, la correction est réalisée à chaque fois qu'un écart est déterminé. Sans sortir du cadre de la présente invention, on pourrait toutefois prévoir une autre périodicité.

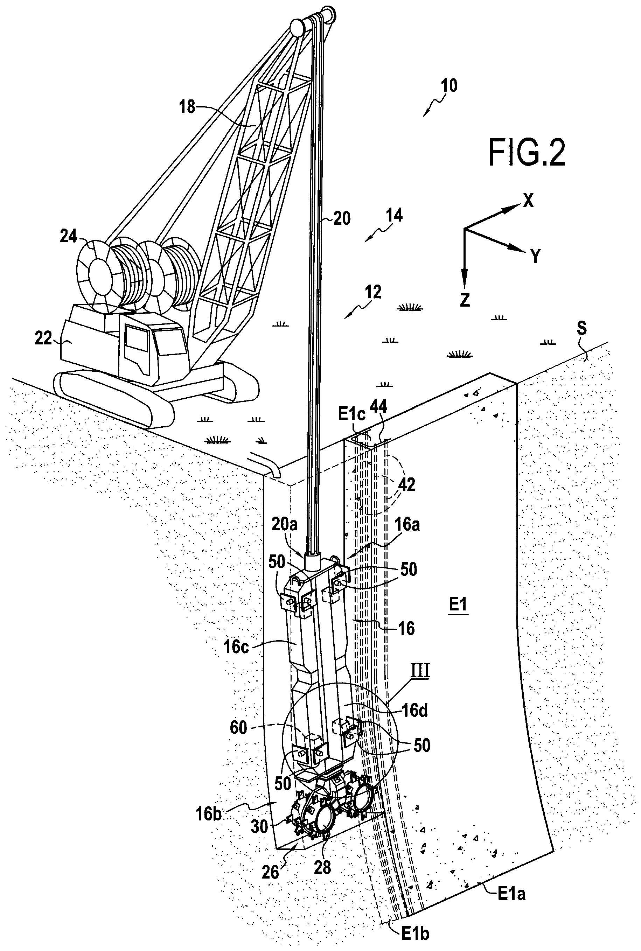

Sur la figure **2****,** on a représenté le châssis **16** dont la position a été corrigée par les patins **50** après qu'un écart a été déterminé entre le châssis et le premier écran **E1.** On comprend donc en se référant à la figure **2** que l'étape de correction a pour effet de modifier la trajectoire du châssis de manière à suivre la déviation du bord longitudinal **E1b** du premier écran **E1.** Le bord longitudinal du châssis reste donc au contact du bord longitudinal du premier écran, et ce tout en mordant dedans afin d'assurer la continuité selon l'axe **X.** En d'autres termes, la position du châssis est corrigée de manière à ce que le bord longitudinal de ce dernier reste en vis-à-vis du bord longitudinal **E1b** du premier écran **E1** en sorte que l'excavation puis le deuxième écran **E2** soient disposés dans la continuité du premier écran **E1,** et ce sur toute la longueur du plus petit des deux écrans.

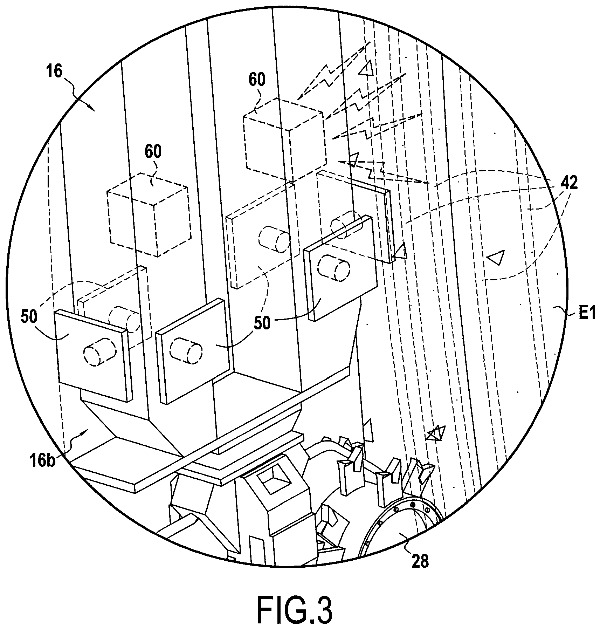

Les patins **50** sont mieux visibles sur la figure **3** qui est une vue de détail de l'extrémité inférieure **16b** du châssis **16.**

Dans cet exemple, la deuxième étape de forage est réalisée sous injection de boue de forage. Puis, après le forage, on remplit l'excavation de béton tout en évacuant la boue de forage. Une cage d'armature pourra également être insérée dans l'excavation avant l'injection du béton.

On va maintenant expliquer plus en détail comment l'écart δ entre le châssis **16** et le premier écran est déterminé.

Selon un aspect avantageux de l'invention, on mesure périodiquement une grandeur physique au cours de la deuxième étape de forage, et l'écart entre le châssis **16** et le premier écran **E1** est déterminé à l'aide des valeurs mesurées de ladite grandeur physique.

De préférence, on s'intéresse aux variations de la grandeur physique qui sont susceptibles d'intervenir au cours de la deuxième étape de forage. En conséquence, les variations de la grandeur physique sont considérées comme correspondant à l'apparition d'un écart δ entre le châssis et le premier écran.

Avantageusement, cette grandeur physique est mesurée à l'aide de capteurs **60** disposés sur le châssis **16** comme cela est illustré sur la figure **3****.**

A titre d'exemple, cette grandeur physique est un champ électrique ou électromagnétique ou magnétique. Une variation de ce champ au cours de la descente du châssis sera interprétée comme signifiant que le châssis s'est écarté du premier écran **E1.**

Certains des patins **50** seront alors actionnés afin de corriger la position du châssis dans le but de réduire ou annuler l'écart déterminé.

A l'aide des figures **1****,** **2****,** **3****,** **6A** et **6B****,** on va décrire un premier mode de mise en oeuvre du procédé selon l'invention.

Dans le premier mode de mise en oeuvre, on a placé au moins une électrode, de préférence plusieurs, dans le premier écran **E1.** Dans cet exemple, les électrodes sont constituées par les barres métalliques longitudinales référencées **42** qui appartiennent, dans cet exemple, à la cage d'armature.

Sans sortir du cadre de la présente invention, les électrodes pourraient être constituées d'autres pièces métalliques, comme par exemple des barres métalliques longitudinales disposées de préférence selon une rangée qui s'étend selon l'épaisseur du premier écran **E1,** et qui ne sont pas reliées les unes aux autres afin de former une cage d'armature.

Avantageusement, les électrodes **42** sont mises à un ou plusieurs potentiels prédéterminés, par exemple 0 volt, ou +/- 50 V. Dans ce premier mode de mise en oeuvre, au cours de la deuxième étape de forage, on mesure une grandeur physique du bord longitudinal **16**c du châssis **16** qui est en regard du bord longitudinal **E1a** du premier écran **E1.** L'écart entre le châssis **16** et le premier écran **E1** est déterminé à partir des valeurs de grandeur physique mesurée. Dans cet exemple, la grandeur physique mesurée est un potentiel électrique.

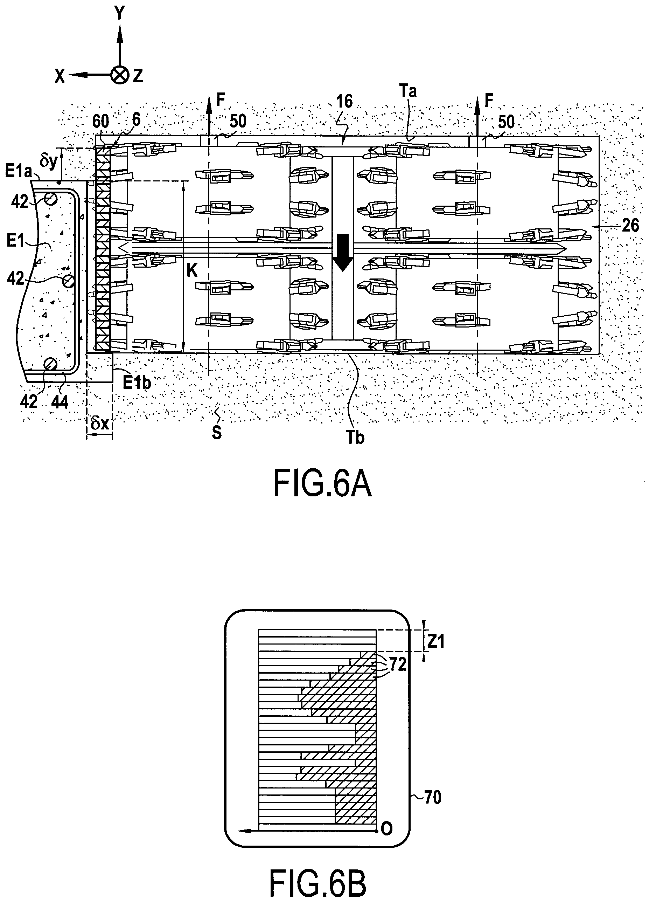

Sur la figure **6A****,** on a illustré, en vue de dessus et de manière schématique, le dispositif de coupe porté par le châssis **16** ainsi que la position des capteurs **60** qui sont fixés au châssis. La référence **K** correspond à l'épaisseur de recouvrement entre le premier écran et le deuxième écran en construction.

Comme on le comprend à l'aide de la figure **6A****,** les capteurs **60** s'étendent selon l'épaisseur du châssis **16** depuis le bord longitudinal **16c** dudit châssis **16.** Les capteurs peuvent également être positionnés sur les faces **16d** du châssis.

Dans l'exemple de la figure **6A****,** les capteurs **60** sont alignés de manière à former une bande de capteurs ; chacun des capteurs **60** est configuré pour mesurer un potentiel électrique. Le résultat de ces mesures est affiché sur un écran **70** sous la forme d'un graphique à barres, où chaque barre **72** est associée à l'un des capteurs **60.**

Sur ce graphique, on constate que le champ électrique n'est pas maximum sur les capteurs du milieu et des extrémités (positions théoriques de l'armature métallique), mais que ces maxima sont décalés le long de la barrette de capteurs. On en déduit que le châssis n'est plus aligné avec le bord longitudinal **E1a** du premier écran **E1.** Il est donc déterminé l'existence d'un écart δ**y** localisé grâce au décalage des maxima.

Les patins d'appui **50** disposés du côté du châssis qui dépassent de la face du premier écran **E1** sont actionnés de manière à générer une force de poussée **F** sur la face **Ta** de la tranchée afin de réduire l'écart δy déterminé. Par contre réaction, cette poussée **F** a pour effet de déplacer le châssis **16** dans une direction opposée au sens de la force de poussée. On corrige ainsi la position du châssis ce qui a pour effet d'augmenter la surface de recouvrement entre le bord longitudinal du châssis et le bord longitudinal du premier écran, ce qui va permettre d'assurer la continuité entre les premier et deuxième écrans.

Dans cet exemple, la correction de la position du châssis est réalisée en temps réel, de manière automatique ou manuelle, à l'aide des signaux mesurés par les capteurs **60.**

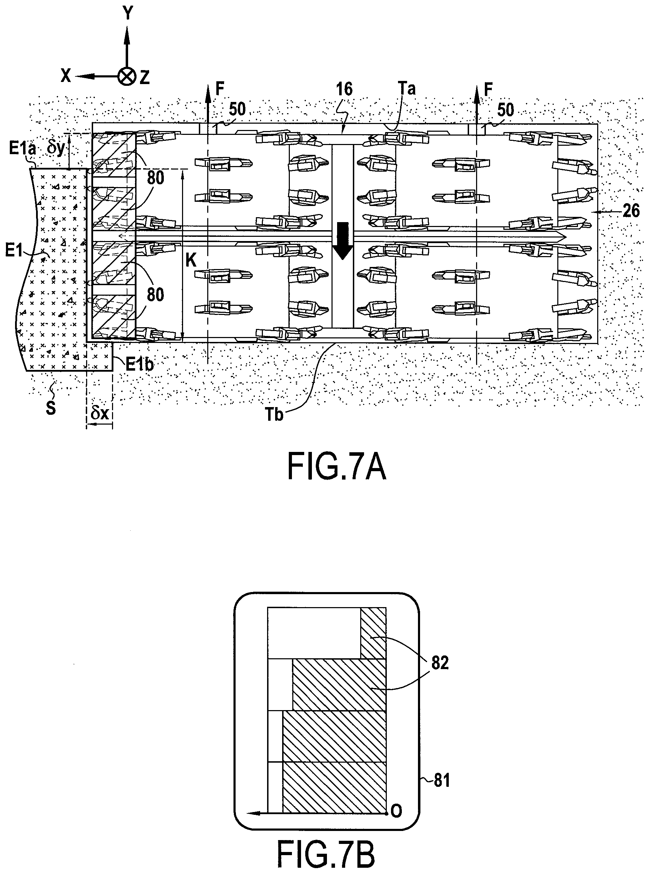

A l'aide des figures **7A** et **7B****,** on va maintenant décrire un deuxième mode de mise en oeuvre du procédé selon l'invention.

Dans ce second mode de mise en oeuvre, on fabrique le premier écran **E1** à partir d'un mélange d'un liant hydraulique et d'un marqueur.

Dans cet exemple, le liant hydraulique est un coulis de béton tandis que le marqueur est une source radioactive, en l'espèce du chlorure de potassium. Ce marqueur pourrait toutefois être remplacé par exemple par des éléments métalliques (poudre de fer par exemple) ou tout autre élément constituant un marqueur.

Selon le procédé, au cours de la deuxième étape de forage, on détecte la présence du marqueur à l'aide de plusieurs détecteurs **80,** en l'espèce des détecteurs de rayons Gamma configurés pour détecter des émissions radioactives. Selon ce procédé, on détermine l'écart δy entre le châssis **16** et le premier écran **E1** à partir des valeurs fournies par les détecteurs **80.** Ces valeurs sont de préférence affichées sur un écran **81** sous la forme d'un graphique à barres. Chaque barre **82** est représentative de l'intensité du signal reçu par chacun des détecteurs **80.** On constate là encore que le châssis **16** a subi une déviation selon la direction **Y** et présente un écart δy par rapport au premier écran **E1.** Là encore, comme dans le premier mode de mise en oeuvre, les patins d'appui **50** seront actionnés de manière à corriger la position du châssis **16** en sorte de réduire l'écart δy déterminé.

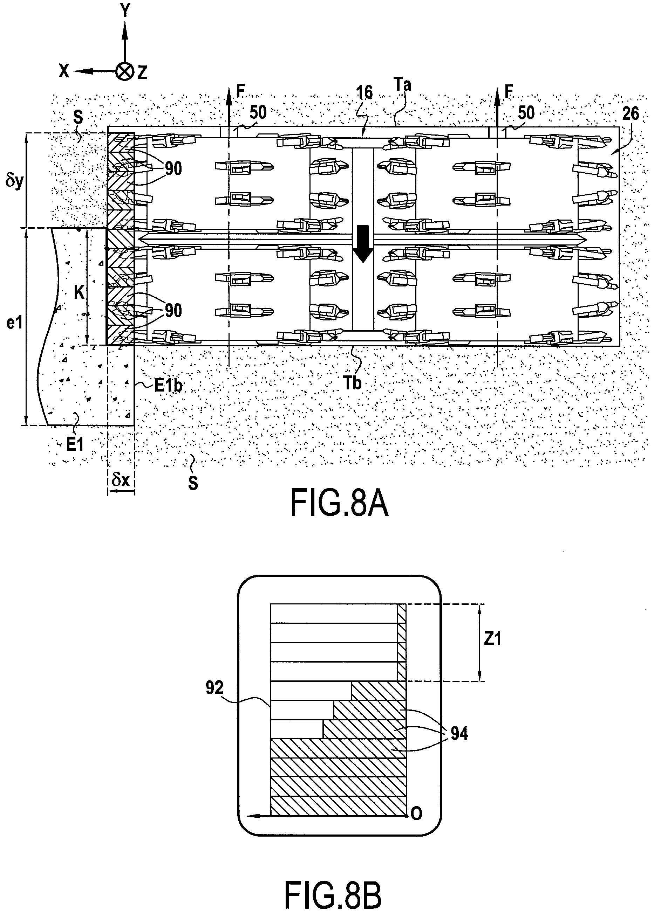

A l'aide des figures **8A** et **8B****,** on va décrire un troisième mode de mise oeuvre du procédé selon l'invention.

Dans ce troisième mode de mise en oeuvre, le bord longitudinal **16c** du châssis **16** est muni de capteurs **90** qui permet de mesurer au cours de la deuxième étape de forage la résistivité électrique du milieu au contact des capteurs **90.** Toujours selon ce procédé, on détermine l'écart δy entre le châssis **16** et le premier écran à partir des mesures fournies par les capteurs **90.** Ces mesures sont affichées sur un écran **92** sous la forme d'un graphique à barres où chacune des barres **94** est représentative de l'intensité de la résistivité électrique mesurée par chacun des capteurs **90.** Dans cet exemple, on constate qu'il existe une zone Z1 pour laquelle les capteurs ont mesuré une résistivité très faible. On en déduit, de manière manuelle ou automatique, que le châssis s'est décalé d'un écart δy selon la direction **Y** du côté des capteurs ayant mesuré une résistivité faible. Là encore, la position du châssis **16** est corrigée en actionnant les patins d'appui **50** de manière à réduire l'écart δy déterminé.

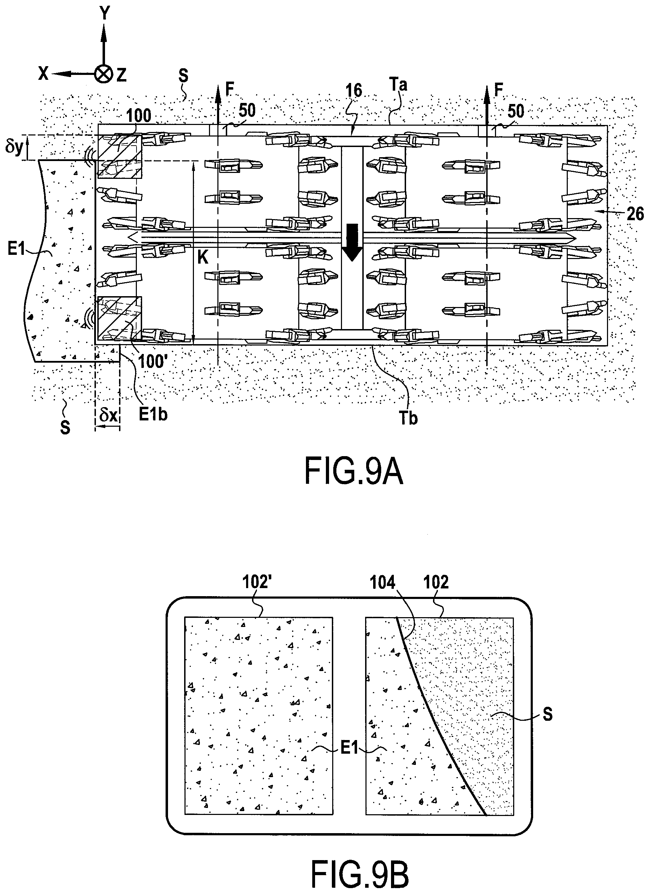

A l'aide des figures **9A** et **9B****,** on va maintenant décrire un quatrième mode de mise en oeuvre du procédé selon l'invention. Dans ce quatrième mode de mise en oeuvre, le châssis **16** comporte des sources émettrices et réceptrices d'ondes **100, 100'** qui sont disposées de part et d'autre de l'épaisseur du châssis. Selon ce procédé, au cours de la deuxième étape de forage, les sources émettrices et réceptrices d'ondes **100, 100'** émettent des ondes vers le premier écran **E1** puis mesurent les ondes réfléchies par ledit premier écran **E1.** L'écart δy entre le châssis et le premier écran est déterminé à partir des mesures fournies par les sources émettrices et réceptrices d'ondes. Dans cet exemple, les sources émettrices et réceptrices d'ondes **100, 100'** sont des sonars. L'image acoustique obtenue par les sources émettrices et réceptrices d'ondes **100, 100'** est affichée sur la forme d'images **102, 102'.** Contrairement à l'image **102,** on constate que l'image **102'** présente une discontinuité **104** qui est représentative d'une discontinuité du milieu. On en déduit que le châssis s'est décalé d'un écart δy du côté du capteur qui a permis d'identifier la discontinuité **104.** Là encore, la position du châssis **16** est corrigée en actionnant les patins d'appui **50** de manière à réduire l'écart δy déterminé.

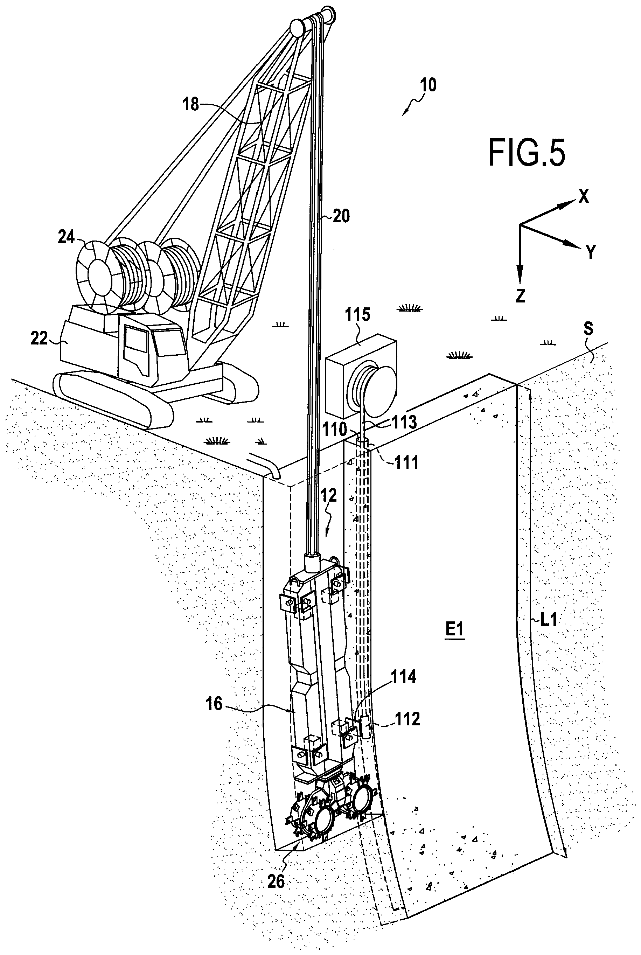

A l'aide de la figure **5****,** on va maintenant décrire un cinquième mode de mise en oeuvre de l'invention. Dans ce cinquième mode de réalisation, on ménage au moins une cavité longitudinale **110** dans le premier écran, cette cavité longitudinale **110** s'étendant sur sensiblement toute la longueur **L** du premier écran. Dans ce procédé, au cours de la deuxième étape de forage, on descend un émetteur **112** dans la cavité **110** à une vitesse identique à la vitesse de descente du châssis **16.** Pour ce faire, l'émetteur **112** est par exemple relié à l'extrémité inférieure d'un câble **113,** ce dernier étant relié à un enrouleur motorisé **115** disposé en surface.

Comme on le constate sur la figure **5****,** le châssis **16** est pourvu d'un récepteur **114.** Dans cet exemple, le récepteur **114** est fixé sur le bord longitudinal du châssis **16.** Conformément à l'invention, l'émetteur **112** émet un signal qui est reçu par le récepteur **114.** On détermine l'écart éventuel entre le châssis et le premier écran à partir du signal reçu par le récepteur **114.**

Bien évidemment, sans sortir du cadre de la présente invention, on pourrait inverser l'émetteur et le récepteur.

Dans cet exemple, la cavité longitudinale **110** est constituée par une pièce creuse **111** qui est placée dans le premier écran lors de sa fabrication. Dans cet exemple, la pièce creuse **111** est constituée d'un tube. Par ailleurs, la position en X Y Z de la cavité dans le premier écran **E1** est connue.

Selon un sixième mode de réalisation, la cavité longitudinale décrite en référence à la figure **5****,** n'est pas ménagée dans le premier écran **E1** mais dans le sol au voisinage du premier écran **E1.** Sa position en X Y Z est connue. Dans cette variante, au cours de la deuxième étape de forage, on descend un émetteur (respectivement un récepteur) dans la cavité à une vitesse identique à la vitesse de descente du châssis, ledit châssis étant quant à lui équipé d'un récepteur (respectivement d'un émetteur). De manière similaire au cinquième mode de mise en oeuvre de l'invention, l'émetteur émet un signal qui est reçu par le récepteur. Là encore, l'écart entre le châssis **16** et le premier écran **E1** est déterminé à partir du signal reçu par le récepteur. De manière similaire aux autres modes de mise en oeuvre, la correction de la position du châssis **16** est réalisée en actionnant les patins d'appui **50.** De préférence, plusieurs cavités sont utilisées dans chacune desquelles on descend un émetteur (respectivement un récepteur), et ce afin d'améliorer les mesures.

## Revendications

1. Procédé de fabrication d'une paroi continue dans un sol, dans lequel :
• on fournit une machine d'excavation (14) comportant un châssis (16) ayant une direction longitudinale (U), ledit châssis ayant une extrémité inférieure et portant un dispositif de coupe disposé en son extrémité inférieure ;
• on réalise une étape de fabrication d'un premier écran (E1) dans le sol, qui comprend une première étape de forage à l'aide de la machine d'excavation (14);
• on réalise une deuxième étape de forage à l'aide de la machine d'excavation afin de fabriquer un deuxième écran (E2) dans le sol qui soit juxtaposé au premier écran (E1) de sorte que les premier et deuxième écrans soient sécants ;
procédé dans lequel, au cours de la deuxième étape de forage :
• on détermine périodiquement un écart (δ) entre le châssis (16) et le premier écran (E1) ; et
• on corrige périodiquement la position du châssis afin de réduire l'écart (δ) déterminé à l'étape précédente en sorte de maintenir un recouvrement entre le bord longitudinal du châssis et le bord longitudinal du premier écran, de manière que le deuxième écran (E2) soit sécant au premier écran (E1) sur toute la longueur du plus court des premier et deuxième écrans, grâce à quoi on forme la paroi continue.

2. Procédé selon la revendication **1, caractérisé en ce que**, au cours de la deuxième étape de forage, on mesure périodiquement une grandeur physique, et **en ce que** l'écart entre le châssis (16) et le premier écran (E1) est déterminé à l'aide des valeurs mesurées de ladite grandeur physique.

3. Procédé selon la revendication **1** ou **2, caractérisé en ce qu'**on place au moins une électrode dans le premier écran (E1), **en ce que**, au cours de la deuxième étape de forage, on mesure une grandeur physique au moins du bord longitudinal (16c) du châssis (16) qui est en regard du bord longitudinal (E1a) du premier écran (E1), et **en ce qu'**on détermine l'écart entre le châssis (16) et le premier écran (E1) à partir des valeurs de grandeurs physiques mesurées.

4. Procédé selon la revendication **3,** dans lequel on place une pluralité d'électrodes dans le premier écran, les électrodes étant disposées selon une rangée qui s'étend selon l'épaisseur du premier écran, et dans lequel les électrodes (42) sont mises à au moins un potentiel prédéterminé.

5. Procédé selon l'une quelconque des revendications **2** à **4, caractérisé en ce que** la grandeur physique mesurée est un potentiel électrique, un champ électrique, un champ électromagnétique ou un champ magnétique.

6. Procédé selon l'une quelconque des revendications **1** à **5,** dans lequel on fabrique le premier écran (E1) à partir d'un mélange d'un liant hydraulique et d'un marqueur, dans lequel, au cours de la deuxième étape de forage, on détecte la présence du marqueur à l'aide d'au moins un détecteur (80) disposé dans le châssis, et dans lequel, on détermine l'écart (δy) entre le châssis (16) et le premier écran (E1) à partir des valeurs fournies par le détecteur.

7. Procédé selon la revendication **6,** dans lequel le bord longitudinal du châssis est muni d'au moins une bande de détecteurs (80) qui s'étend selon au moins l'épaisseur du châssis (16).

8. Procédé selon l'une quelconque des revendications **1** à **7,** dans lequel au moins une pièce métallique est placée dans le premier écran lors de sa fabrication, ladite pièce métallique (42) s'étendant selon la longueur (L1) du premier écran (E1), dans lequel le châssis est muni d'un appareil de mesure, et dans lequel, au cours de la deuxième étape de forage, on détermine l'écart (δy) entre le châssis et le premier écran à partir des valeurs mesurées par l'appareil de mesure.

9. Procédé selon la revendication **8,** dans lequel on place une pluralité de pièces métalliques dans le premier écran, les pièces métalliques (42) étant disposées selon une rangée qui s'étend selon l'épaisseur du premier écran et dans lequel les pièces métalliques sont mises à un potentiel déterminé.

10. Procédé selon l'une quelconque des revendications **1** à **9,** dans lequel le bord longitudinal (16) du châssis (16) est muni de capteurs permettant de mesurer, au cours de la deuxième étape de forage, la résistivité électrique ou la résistance mécanique du milieu au contact des capteurs (60), et dans lequel on détermine l'écart (δy) entre le châssis (16) et le premier écran (E1) à partir des mesures fournies par les capteurs (40).

11. Procédé selon l'une quelconque des revendications **1** à **10,** dans lequel le châssis (16) comporte des sources émettrices et réceptrices d'ondes qui sont disposées de part et d'autre de l'épaisseur du châssis, dans lequel, au cours de la deuxième étape de forage, les sources émettrices et réceptrices d'ondes (100, 100') émettent des ondes vers le premier écran (E1) puis mesurent les ondes réfléchies, et dans lequel on détermine l'écart (δy) entre le châssis et le premier écran à partir des mesures fournies par les sources émettrices et réceptrices d'ondes.

12. Procédé selon l'une quelconque des revendications **1** à **11,** dans lequel on ménage au moins une cavité longitudinale (110) dans le premier écran (E1), et dans lequel, au cours de la deuxième étape de forage, on descend un émetteur (112), respectivement un récepteur, dans la cavité à une vitesse identique à la vitesse de descente du châssis (16), ledit châssis étant quant à lui équipé d'un récepteur (114), respectivement d'un émetteur, dans lequel l'émetteur (112) émet un signal qui est reçu par le récepteur (114), et dans lequel on détermine l'écart entre le châssis et le premier écran à partir du signal reçu par le récepteur (114).

13. Procédé selon la revendication **12, caractérisé en ce que** la cavité longitudinale (110) est constituée par une pièce creuse (111) placée dans le premier écran lors de sa fabrication.

14. Procédé selon l'une quelconque des revendications **1** à **13,** dans lequel on ménage au moins une cavité longitudinale dans le sol au voisinage du premier écran (E1), et dans lequel, au cours de la deuxième étape de forage, on descend un émetteur (112) respectivement un récepteur (114), dans la cavité à une vitesse identique à la vitesse de descente du châssis, ledit châssis étant quant à lui équipé d'un récepteur, respectivement d'un émetteur, dans lequel l'émetteur émet un signal qui est reçu par le récepteur, et dans lequel on détermine l'écart entre le châssis et le premier écran (E2) à partir du signal reçu par le récepteur.

15. Installation (10) de fabrication d'une paroi continue dans un sol (S), pour la mise en oeuvre du procédé selon l'une quelconque des revendications précédentes, comportant :
• des moyens (12) pour fabriquer un premier et un deuxième écran dans le sol qui comprend une machine d'excavation (14) comportant un châssis (16) ayant une extrémité inférieure (16b) et portant un dispositif de coupe (20) disposé en son extrémité inférieure ;
• des moyens de détermination (80) pour déterminer périodiquement l'écart entre le châssis et le premier écran lors de la fabrication du deuxième écran dans le sol ; et
• des moyens de correction (50) pour corriger périodiquement la position du châssis (16) afin de réduire l'écart déterminé par les moyens de détermination entre le châssis (16) et le premier écran (E1), en sorte de maintenir un recouvrement entre le bord longitudinal du châssis et le bord longitudinal du premier écran, de manière que le deuxième écran (E2) soit sécant au premier écran (E1) sur toute la longueur du plus court des premier et deuxième écrans, grâce à quoi on forme la paroi continue.

## Patentansprüche

1. Verfahren zur Herstellung einer durchgehenden Wand in einem Boden, bei dem:
- eine Aushubmaschine (14) bereitgestellt wird, umfassend ein Gestell (16) mit einer Längsrichtung (U), wobei das Gestell ein unteres Ende hat und eine Schneidvorrichtung trägt, die an seinem unteren Ende angeordnet ist,
- ein Schritt der Herstellung einer ersten Bahn (E1) im Boden durchgeführt wird, der einen ersten Schritt des Bohrens mit Hilfe der Aushubmaschine (14) umfasst,
- ein zweiter Schritt des Bohrens mit Hilfe der Aushubmaschine durchgeführt wird, um einer zweiten Bahn (E2) im Boden herzustellen, die an die erste Bahn (E1) grenzt, so dass sich die erste und die zweite Bahn schneiden,
wobei bei dem Verfahren während des zweiten Schrittes des Bohrens:
- periodisch ein Abstand (δ) zwischen dem Gestell (16) und der ersten Bahn (E1) bestimmt wird, und
- periodisch die Position des Gestells korrigiert wird, um den in dem vorhergehenden Schritt bestimmten Abstand (δ) zu verringern, um eine Überlappung zwischen dem Längsrand des Gestells und dem Längsrand der ersten Bahn aufrechtzuerhalten, so dass die zweite Bahn (E2) die erste Bahn (E1) über die gesamte Länge der kürzeren der ersten und der zweiten Bahn schneidet, wodurch die durchgehende Wand gebildet wird.

2. Verfahren gemäß Anspruch 1, **dadurch gekennzeichnet, dass** während des zweiten Bohrschrittes periodisch eine physikalische Größe gemessen wird, und dass der Abstand zwischen dem Gestell (16) und der ersten Bahn (E1) mit Hilfe der gemessenen Werte der physikalischen Größe bestimmt wird.

3. Verfahren gemäß Anspruch 1 oder 2, **dadurch gekennzeichnet, dass** mindestens eine Elektrode in der ersten Bahn (E1) angeordnet wird, und dass während des zweiten Bohrschrittes eine physikalische Größe mindestens des Längsrandes (16c) des Gestells (16), der dem Längsrand (E1 a) der ersten Bahn (E1) gegenüberliegt, gemessen wird, und dass der Abstand zwischen dem Gestell (16) und der ersten Bahn (E1) auf Basis der gemessenen werden von physikalischen Größen bestimmt wird.

4. Verfahren gemäß Anspruch 3, bei dem eine Vielzahl von Elektroden in der ersten Bahn angeordnet wird, wobei die Elektroden in einer Reihe angeordnet sind, die sich entlang der Dicke der ersten Bahn erstreckt, und bei dem die Elektroden (42) auf mindestens ein vorbestimmtes Potential gebracht werden.

5. Verfahren gemäß einem der Ansprüche 2 bis 4, **dadurch gekennzeichnet, dass** die gemessene physikalische Größe ein elektrische Potential, ein elektrisches Feld, ein elektromagnetisches Feld oder ein Magnetfeld ist.

6. Verfahren gemäß einem der Ansprüche 1 bis 5, bei dem die erste Bahn (E1) aus einer Mischung eines hydraulischen Bindemittels und eines Markers hergestellt wird, und bei dem während des zweiten Bohrschrittes das Vorhandensein des Markers mit Hilfe mindestens eines im Gestell angeordneten Detektors (80) erfasst wird, und bei dem der Abstand (δy) zwischen dem Gestell (16) und der ersten Bahn (E1) auf Basis der vom Detektor gelieferten Werte bestimmt wird.

7. Verfahren gemäß Anspruch 6, bei dem der Längsrand des Gestells mit mindestens einem Band von Detektoren (80) versehen ist, das sich entlang mindestens der Dicke des Gestells (16) erstreckt.

8. Verfahren gemäß einem der Ansprüche 1 bis 7, bei dem mindestens ein metallisches Stück in der ersten Bahn bei ihrer Herstellung angeordnet wird, wobei sich das metallische Stück (42) entlang der Länge (L1) der ersten Bahn (E1) erstreckt, bei dem das Gestell mit einem Messgerät versehen ist, und bei dem während des zweiten Bohrschritts der Abstand (δy) zwischen dem Gestell und der ersten Bahn auf Basis der von dem Messgerät gemessenen Werte bestimmt wird.

9. Verfahren gemäß Anspruch 8, bei dem eine Vielzahl von metallischen Stücken in der ersten Bahn angeordnet wird, wobei die metallischen Stücke (42) in einer Reihe angeordnet sind, die sich entlang der Dicke der ersten Bahn erstreckt, und bei dem die metallischen Stücke auf ein bestimmtes Potential gebracht werden.

10. Verfahren gemäß einem der Ansprüche 1 bis 9, bei dem der Längsrand (16) des Gestells (16) mit Sensoren versehen ist, die es ermöglichen, während des zweiten Bohrschrittes die elektrische Widerstandsfähigkeit oder den mechanischen Widerstand des mit den Sensoren (60) in Kontakt befindlichen Mediums zu messen, und bei dem der Abstand (δy) zwischen dem Gestell (16) und der ersten Bahn (E1) auf Basis der von den Sensoren (40) gelieferten Messungen bestimmt wird.

11. Verfahren gemäß einem der Ansprüche 1 bis 10, bei dem das Gestell (16) Sende- und Empfangsquellen von Wellen umfasst, die beiderseits der Dicke des Gestells angeordnet sind, und bei dem während des zweiten Bohrschrittes die Sende- und Empfangsquellen von Wellen (100, 100') Wellen zu der ersten Bahn (E1) senden, dann die reflektierten Wellen Messen, und bei dem der Abstand (δy) zwischen dem Gestell und dem ersten Schirm auf Basis der von den Sende- und Empfangsquellen von Wellen gelieferten Messungen bestimmt wird.

12. Verfahren gemäß einem der Ansprüche 1 bis 11, bei dem mindestens ein länglicher Hohlraum (110) in der ersten Bahn (E1) vorgesehen wird, und bei dem während des zweiten Bohrschrittes ein Sender (112) bzw. ein Empfänger in den Hohlraum mit einer identischen Geschwindigkeit wie die Absenkgeschwindigkeit des Gestells (16) abgesenkt wird, wobei das Gestell seinerseits mit einem Empfänger (114) bzw. einem Sender ausgestattet ist, wobei der Sender (112) ein Signal sendet, das von dem Empfänger (114) empfangen wird, und bei dem der Abstand zwischen dem Gestell und dem ersten Schirm auf Basis des von dem Empfänger (114) empfangenen Signals bestimmt wird.

13. Verfahren gemäß Anspruch 12, **dadurch gekennzeichnet, dass** der längliche Hohlraum (110) von einem hohlen Stück (111) gebildet ist, das in der ersten Bahn bei seiner Herstellung angeordnet wird.

14. Verfahren gemäß einem der Ansprüche 1 bis 13, bei dem mindestens ein länglicher Hohlraum im Boden in der Nähe der ersten Bahn (E1) vorgesehen wird, und bei dem während des zweiten Bohrschrittes ein Sender (112) bzw. ein Empfänger (114) in den Hohlraum mit einer identischen Geschwindigkeit wie die Absenkgeschwindigkeit des Gestells abgesenkt wird, wobei das Gestell seinerseits mit einem Empfänger bzw. einem Sender ausgestattet ist, wobei der Sender ein Signal sendet, das von dem Empfänger empfangen wird, und bei dem der Abstand zwischen dem Gestell und der ersten Bahn (E2) auf Basis des von dem Empfänger empfangenen Signals bestimmt wird.

15. Anlage (10) zur Herstellung einer durchgehenden Wand in einem Boden (S) für den Einsatz des Verfahrens gemäß einem der vorhergehenden Ansprüche, umfassend:
- Mittel (12), um eine erste und eine zweite Bahn im Boden herzustellen, umfassend eine Aushubmaschine (14), die ein Gestell (16) mit einem unteren Ende (16b) umfasst und eine Schneidvorrichtung (20) trägt, die an seinem unteren Ende angeordnet ist,
- Bestimmungsmittel (80), um periodisch den Abstand zwischen dem Gestell und der ersten Bahn bei der Herstellung der zweiten Bahn im Boden zu bestimmen, und
- Korrekturmittel (50), um periodisch die Position des Gestells (16) zu korrigieren, um den durch die Bestimmungsmittel bestimmten Abstand zwischen dem Gestell (16) und der ersten Bahn (E1) zu verringern, um eine Überlappung zwischen dem Längsrand des Gestells und dem Längsrand der ersten Bahn aufrecht zu erhalten, so dass die zweite Bahn (E2) die erste Bahn (E1) über die gesamte Länge der kürzeren der ersten und zweiten Bahnen schneidet, wodurch die durchgehende Wand gebildet wird.

## Claims

1. A method of making a continuous wall in ground, the method comprising the following steps:
• providing an excavation machine (14) having a frame (16) with a longitudinal direction (U), said frame having a bottom end and carrying a cutter device arranged at its bottom end;
• performing a step of making a first screen (E1) in the ground, which step includes a first boring step using the excavation machine (14); and
• performing a second boring step using the excavation machine in order to make a second screen (E2) in the ground that is juxtaposed with the first screen (E1) in such a manner that the first and second screens are secant;
in which method, the second boring step includes:
• periodically determining an offset (δ) between the frame (16) and the first screen (E1); and
• periodically correcting the position of the frame so as to reduce the previously determined offset (δ) and maintain overlap between the longitudinal side of the frame and the longitudinal side of the first screen, in such a manner that the second screen (E2) is secant with the first screen (E1) over the entire length of the shorter of the first and second screens, thereby forming the wall that is continuous.

2. A method according to claim 1, **characterized in that**, during the second boring step, a physical magnitude is measured periodically, and **in that** the offset between the frame (16) and the first screen (E1) is determined from the measured values of said physical magnitude.

3. A method according to claim 1 or claim 2, **characterized in that** at least one electrode is placed in the first screen (E1), **in that**, during the second boring step, a physical magnitude is measured at least from the longitudinal side (16c) of the frame (16) that faces the longitudinal side (E1a) of the first screen (E1), and **in that** the offset between the frame (16) and the first screen (E1) is determined from the measured physical magnitude values.

4. A method according to claim 3, wherein a plurality of electrodes are placed in the first screen, the electrodes being arranged in a row that extends across the thickness of the first screen, and wherein the electrodes (42) are set to at least one predetermined potential.

5. A method according to any one of claims 2 to 4, **characterized in that** the measured physical magnitude is an electric potential, an electric field, an electromagnetic field, or a magnetic field.

6. A method according to any one of claims 1 to 5, wherein the first screen (E1) is made from a mixture of hydraulic binder and a marker, wherein, during the second boring step, the presence of the marker is detected by using at least one detector (80) arranged in the frame, and wherein the offset (δy) between the frame (16) and the first screen (E1) is determined from the values supplied by the detector.

7. A method according to claim 6, wherein the longitudinal side of the frame is provided with at least one strip of detectors (80) that extend at least across the thickness of the frame (16).

8. A method according to any one of claims 1 to 7, wherein at least one metal part is placed in the first screen while it is being made, said metal part (42) extending along the length (L1) of the first screen (E1), wherein the frame is provided with a measuring appliance, and wherein, during the second boring step, the offset (δy) between the frame and the first screen is determined from values measured by the measuring appliance.

9. A method according to claim 8, wherein a plurality of metal parts are placed in the first screen, the metal parts (42) being arranged in a row that extends across the thickness of the first screen, and wherein the metal parts are set to a determined potential.

10. A method according to any one of claims 1 to 9, wherein the longitudinal side (**16**) of the frame (16) is provided with sensors capable, during the second boring step, of measuring the electrical resistivity or the mechanical strength of the medium in contact with the sensors (60), and wherein the offset (δy) between the frame (16) and the first screen (E1) is determined from the measurements supplied by the sensors (40).

11. A method according to any one of claims 1 to 10, wherein the frame (16) includes wave emitter and receiver sources that are arranged on either side of the thickness of the frame, wherein, during the second boring step, the wave emitter and receiver sources (100, 100') emit waves towards the first screen (E1) and then measure the reflected waves, and wherein the offset (δy) between the frame and the first screen is determined from the measurements supplied by the wave emitter and receiver sources.

12. A method according to any one of claims 1 to 11, wherein at least one longitudinal cavity (110) is arranged in the first screen (E1), and wherein, during the second boring step, an emitter (112) or a receiver as the case may be is lowered down the cavity at a speed identical to the downward speed of the frame (16), said frame being fitted with a receiver (114) or with an emitter as the case may be, wherein the emitter (112) emits a signal that is received by the receiver (114), and wherein the offset between the frame and the first screen is determined from the signal received by the receiver (114).

13. A method according to claim 12, **characterized in that** the longitudinal cavity (110) is constituted by a hollow part (111) placed in the first screen while it is being made.

14. A method according to any one of claims 1 to 13, wherein at least one longitudinal cavity is arranged in the ground in the vicinity of the first screen (E1), and wherein during the second boring step, an emitter (112) or a receiver (114) as the case may be is lowered down the cavity at a speed identical to the downward speed of the frame, said frame being fitted with a receiver or with an emitter as the case may be, wherein the emitter emits a signal that is received by the receiver and wherein the offset between the frame and the first screen (E2) is measured from the signal received by the receiver.

15. An installation (10) for making a continuous wall in ground (S), for performing the method according to any preceding claim, the installation comprising:
• means (12) for making first and second screens in the ground, which means comprise an excavation machine (14) having a frame (16) with a bottom end (16b) and carrying a cutter device (20) arranged at its bottom end;
• determination means (80) for periodically determining the offset between the frame and the first screen while making the second screen in the ground; and
• correction means (50) for periodically correcting the position of the frame (16) so as to reduce the offset as determined by the determination means between the frame (16) and the first screen (E1), and maintain overlap between the longitudinal side of the frame and the longitudinal side of the first screen in such a manner that the second screen (E2) is secant with the first screen (E1) over the entire length of the shorter of the first and second screens, thereby forming the wall that is continuous.
